# EUROPEAN PATENT APPLICATION

(11) **EP 4 703 501 A1**
(43) Date of publication of application: **04.03.2026**
(21) Application number: 24796954.6
(22) Date of filing: 22.04.2024
(51) Int. Cl.: C30B 29/16, C30B 19/02

(54) **METHOD FOR PRODUCING ?-GA2O3/?-GA2O3 LAYERED PRODUCT, AND LAYERED PRODUCT OBTAINED USING SAID PRODUCTION METHOD**

(30) Priority: 25.04.2023 JP 2023071380
(71) Applicant: MITSUBISHI GAS CHEMICAL COMPANY, INC., Chiyoda-ku Tokyo 100-8324 (JP)
(72) Inventor: TADOKORO, Hiroaki, Tokyo 125-8601 (JP); MIYAMOTO, Miyuki, Tokyo 125-8601 (JP); CHEN, Zhijin, Tokyo 125-8601 (JP)
(74) Representative: Gille Hrabal Partnerschaftsgesellschaft mbB Patentanwälte
(86) International application number: PCT/JP2024/015664
(87) International publication number: WO 2024/225207

(57) **Abstract**

According to the present invention, there can be provided a method for producing a β-Ga₂O₃/β-Ga₂O₃ multilayer body, the method being characterized in that it comprises: mixing (1) Ga₂O₃ as a solute, with (2) a combination of either PbO or PbF₂ as a solvent and any one selected from the group consisting of Bi₂O₃, B₂O₃, and V₂O₅, as a solvent (provided that a combination of PbO and Bi₂O₃ is excluded), and melting the mixture; and then allowing a β-Ga₂O₃ substrate to directly come into contact with the resulting melt, so that β-Ga₂O₃ single crystals are allowed to grow on the β-Ga₂O₃ substrate according to liquid phase epitaxy.

## Description

### Technical Field

The present invention relates to a method for producing a β-Ga₂O₃/β-Ga₂O₃ multilayer body and a multilayer body obtained by said method.

### Background Art

Power devices are one of the key devices for improving power usage efficiency to realize a low-carbon society, and are mainly used as elements to configure inverters that convert DC-AC power and adjust AC voltage and frequency. Upon the above-mentioned conversion, energy loss due to the resistance when current flows through the element and generation of wasted current due to the recovery process of charge distribution in the element, which occurs at the moment when the voltage applied to the element is switched, are inevitable. These loss percentages vary with power and frequency, but generally range from a few percent to about a dozen percent. Element structures of conventional Si-based power semiconductors have been devised but further improvement of efficiency is becoming difficult because Si is approaching its physical property limit. Therefore, SiC and GaN are being developed as alternative power device materials to Si. SiC and GaN have band gaps of 3.3 eV and 3.4 eV, respectively, and they are materials having wider band gaps than the band gap of Si (i.e., 1.1 eV). The wider the band gap of a material, the higher the breakdown voltage, which represents the electric field at the boundary where charge is prevented from flowing into the semiconductor (avalanche breakdown), and thus the material can provide a device structure that can withstand higher voltages.

β-Ga₂O₃ is a kind of oxide semiconductor that has been adopted to transparent conductive substrates for GaN-based LEDs, solar-blind UV detectors, etc. Recently, it has attracted attention as a material for power devices and is expected to realize high-voltage and high-efficiency power semiconductors that surpass SiC and GaN. This is due to the fact that the band gap of β-Ga₂O₃ is expected to be 4.5-4.9 eV, which is wider than those of SiC and GaN. Another advantage of β-Ga₂O₃ over SiC and GaN is that it allows growing a crystal from a melt. SiC and GaN have difficulty in growing a crystal from a melt, and have an issue that their substrates are expensive. On the other hand, β-Ga₂O₃ has a melting point at normal pressure, allows bulk crystal growth, and its study and development are progressing through the EFG (Edge-Defined Film-fed Growth) method and the vertical Bridgman method. The former growth method has provided commercially available 2- to 4-inch substrates, and the latter is used for the development of 4-inch substrates.

In order to apply β-Ga₂O₃ to power devices, a β-Ga₂O₃ (epitaxial layer)/β-Ga₂O₃ (substrate) multilayer body consisting of two layers of β-Ga₂O₃ with different residual electron densities is required. The thickness of the epitaxial layer needs to be around several µm to 20 µm, and vapor-phase growth methods such as metal organic chemical vapor deposition (MOCVD), molecular beam epitaxy (MBE), mist CVD, and halide vapor-phase epitaxy (HVPE) have traditionally been used. However, the vapor-phase growth method is a non-thermodynamic growth method and has the disadvantages of poor crystal quality and slow growth rate.

For example, Non Patent literature 1 discloses a method of epitaxial growth of β-Ga₂O₃ on a sapphire substrate by the HVPE method. According to this method, the sapphire substrate and β-Ga₂O₃ have different crystal structures, resulting in multiple rotational domains and an epitaxial layer that is not composed of a single domain. This layer is not strictly a single crystal and cannot be used for power devices. The full width at half maximum of the X-ray rocking curve of the epitaxial layer obtained by the same method is as high as 0.5 deg (1,800 arcsec), indicating low crystallinity. Patent literature 1 also discloses a method of epitaxial growth of β-Ga₂O₃ on a β-Ga₂O₃ substrate by the HVPE method to obtain a β-Ga₂O₃/β-Ga₂O₃ multilayer body (hereinafter simply referred to as a "β-Ga₂O₃ multilayer body"). Although a β-Ga₂O₃/β-Ga₂O₃ multilayer body can be obtained by this method, the growth rate of the epitaxial layer is as low as 2.7-6.0 µm/hr.

On the other hand, the liquid-phase growth method has the advantage of producing a high-quality crystal more easily than the vapor-phase growth method because crystal growth proceeds in principle in thermal equilibrium. The melting point of β-Ga₂O₃ is as high as 1970°C, and it is difficult to maintain a stable melt surface near the melting point, making it difficult to grow β-Ga₂O₃ by the Czochralski method, which is employed for single-crystal silicon and the like. Therefore, a single crystal is grown by the above-mentioned EFG method or vertical Bridgman method. However, a β-Ga₂O₃ multilayer body cannot be obtained by the EFG or the vertical Bridgman method. Examples of a method in which a target substance is dissolved in a suitable solvent, the temperature of the mixed solution is lowered to a supersaturated state, and the target substance is grown from the melt include the static slow-cooling method, the flux method, the floating zone method, the top seeded solution growth (TSSG) method, the solution pulling method, and the liquid-phase epitaxy (LPE) method.

Patent literature 2 discloses a method for obtaining a β-Ga₂O₃ epitaxial layer by the LPE method. According to this method, a β-Ga₂O₃ single-crystal layer is stacked on a sapphire substrate by the LPE method, and a β-Ga₂O₃ multilayer body cannot be obtained because the substrate is made of sapphire. Moreover, the crystal structure of the sapphire substrate is corundum, while the crystal structure of β-Ga₂O₃ is monoclinic, and so they have different crystal structures. In addition, there is a problem of poor crystal quality due to inconsistent lattice constants.

When a β-Ga₂O₃ single-crystal layer is grown by the liquid-phase growth method such as the LPE method, a solvent capable of dissolving β-Ga₂O₃ is required. In Patent literature 2, PbO and PbF₂ are exemplified as solvents, and either one of them is used. In order to establish a stable and well reproducible single-crystal growth method, it is common practice to keep the melt at a temperature about 100-200°C above its melting point so that the solvent and solute are mixed homogeneously. In Patent literature 2, the melt is maintained at 1100°C. The melting points of PbO and PbF₂ are about 886°C and 824°C, respectively. In general, when the temperature of the melt containing either PbO or PbF₂ exceeds 1000°C, some of PbO or PbF₂ volatilizes and the composition of the melt changes, which is not favorable for growing a β-Ga₂O₃ single crystal in a stable and well reproducible manner. In addition, since the vaporized PbO or PbF₂ reacts with the furnace material constituting the crystal growing furnace, the number of times the furnace material can be used is reduced and toxic Pb is volatilized, which increase the cost because the crystal growing furnace needs to have a closed structure or the like.

As mentioned above, the method of allowing β-Ga₂O₃ to grow on a β-Ga₂O₃ substrate by vapor-phase growth, which is used as a method of obtaining a β-Ga₂O₃ multilayer body useful as a power device, has had disadvantages of low crystal quality and slow growth rate. On the other hand, when using a liquid-phase growth method, which is, in principle, close to thermal equilibrium growth and is expected to have high crystallinity and high growth rate, the conventional melt growth method using no solvents has been problematic in that a β-Ga₂O₃ multilayer body cannot be obtained. In addition, when a solvent is used, either PbO or PbF₂ is used as such a solvent, and it has been problematic in that vapor pressure is high and it is difficult to allow β-Ga₂O₃ single crystals to grow stably and at low costs.

### Citation List

### Patent Literature

Patent Literature 1: Japanese Patent No. 6744523
Patent Literature 2: Japanese Patent No. 5794955

Non Patent Literature 1: Journal of the Japanese Association for Crystal Growth, Vol. 42, No. 2, (2015) PP. 141~147

### Summary of Invention

### Technical Problem

It is an object of the present invention to solve at least one of the above-described problems of the prior art. Furthermore, it is another object of the present invention to provide a method for producing a β-Ga₂O₃/β-Ga₂O₃ multilayer body by stacking β-Ga₂O₃ single crystals having high crystallinity and a fast growth rate on a β-Ga₂O₃ substrate, using liquid phase epitaxy.

It is to be noted that, in the present description, the β-Ga₂O₃/β-Ga₂O₃ multilayer body means a product obtained by stacking an epitaxial layer containing β-Ga₂O₃ single crystals on a substrate containing β-Ga₂O₃.

### Solution to Problem

As a result of intensive studies conducted directed towards achieving the aforementioned objects, the present inventors have found that the aforementioned objects can be achieved by the present invention described below. Specifically, the present invention is as follows.
< 1 > A method for producing a β-Ga₂O₃/β-Ga₂O₃ multilayer body, the method being characterized in that it comprises: mixing (1) Ga₂O₃ as a solute, with (2) a combination of either PbO or PbF₂ as a solvent and any one selected from the group consisting of Bi₂O₃, B₂O₃, and V₂O₅, as a solvent (provided that a combination of PbO and Bi₂O₃ is excluded), and melting the mixture; and then allowing a β-Ga₂O₃ substrate to directly come into contact with the resulting melt, so that β-Ga₂O₃ single crystals are allowed to grow on the β-Ga₂O₃ substrate according to liquid phase epitaxy.
< 2 > The production method according to the above < 1 >, wherein the combination (2) above is a combination of PbO as a solvent and any one selected from the group consisting of B₂O₃ and V₂O₅ as a solvent, or a combination of PbF₂ as a solvent and B₂O₃ as a solvent.
< 3 > The production method according to the above < 1 > or < 2 >, wherein the layer containing the β-Ga₂O₃ single crystals formed according to liquid phase epitaxy contains 0.01 mol % or more and 20 mol % or less of a foreign element.
< 4 > The production method according to the above < 3 >, wherein the foreign element is one or more selected from the group consisting of Be, Mg, Ca, Sr, Ba, Ti, Zr, Hf, Fe, Co, Ni, Cu, Zn, Cd, Al, In, Si, Ge, Sn, Pb, and Bi.
< 5 > A β-Ga₂O₃/β-Ga₂O₃ multilayer body obtained by the production method according to any one of the above < 1 > to < 4 >, wherein the multilayer body has a layer containing β-Ga₂O₃ single crystals on a β-Ga₂O₃ substrate.
< 6 > The β-Ga₂O₃/β-Ga₂O₃ multilayer body according to the above < 5 >, wherein the rocking curve half-width in the layer containing the β-Ga₂O₃ single crystals is 5 to 100 arcsec.
< 7 > An optical material containing the β-Ga₂O₃/β-Ga₂O₃ multilayer body according to the above < 5 > or < 6 >.
< 8 > An electronic device containing the β-Ga₂O₃/β-Ga₂O₃ multilayer body according to the above < 5 > or < 6 >.

### Advantageous Effects of Invention

According to a preferred embodiment of the present invention, evaporation of the solvents is suppressed, and stable crystal growth can be performed with little compositional variation. In addition, consumption of furnace materials can be suppressed, and the growth furnace does not need to be a closed system. Accordingly, production at low costs becomes possible. Moreover, since the crystal growth method is a liquid phase growth method, it is possible to allow a β-Ga₂O₃ single crystal layer to growth with high crystallinity and a high growth rate. The β-Ga₂O₃ multilayer body produced in this embodiment can be utilized for electronic devices using β-Ga₂O₃ multilayer bodies, which are expected to develop in the future, and in particular, for power devices. Furthermore, it is also expected that the present β-Ga₂O₃ multilayer body will be utilized as an optical material.

### Brief Description of Drawings

[Figure 1] Figure 1 is a phase diagram of PbO-B₂O₃.
[Figure 2] Figure 2 is a schematic diagram showing one example of a common LPE growth furnace.
[Figure 3] Figure 3 shows the X-ray rocking curve of the (002) surface of the epitaxial layer of the multilayer body obtained in Example 1.

### Description of Embodiments

One embodiment of the present invention relates to a method for producing a β-Ga₂O₃/β-Ga₂O₃ multilayer body, the method being characterized in that it comprises: mixing (1) Ga₂O₃ as a solute, with (2) a combination of either PbO or PbF₂ as a solvent and any one selected from the group consisting of Bi₂O₃, B₂O₃, and V₂O₅, as a solvent (provided that a combination of PbO and Bi₂O₃ is excluded), and melting the mixture; and then allowing a β-Ga₂O₃ substrate to directly come into contact with the resulting melt, so that β-Ga₂O₃ single crystals are allowed to grow on the β-Ga₂O₃ substrate according to liquid phase epitaxy.

In one embodiment of the present invention, an aspect in which the combination (2) above is a combination of PbO as a solvent and any one selected from the group consisting of B₂O₃ and V₂O₅ as a solvent, or an aspect in which the combination (2) above is a combination of PbF₂ as a solvent and B₂O₃ as a solvent, is preferable.

The principle of one embodiment of the present invention will be described below.

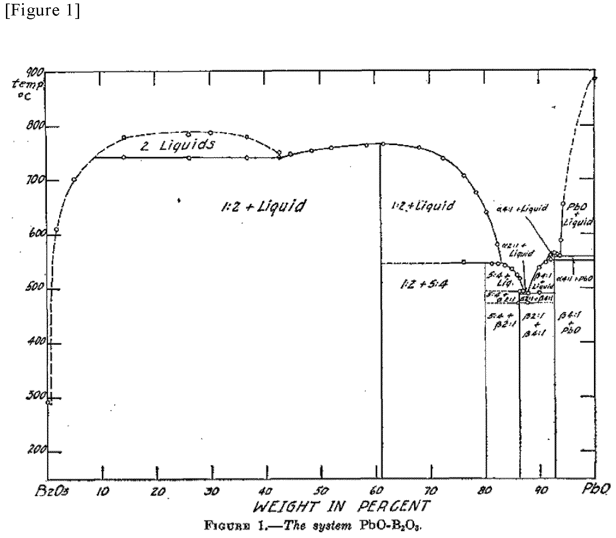

Figure 1 is a phase diagram of PbO-B₂O₃ (Reference: The System PbO-B₂O₃, J. Res. Natl. Bur. Stand., 18, 585-593, 1937, R. F. Geller, et al.). The combination of either PbO or PbF₂ as a solvent and any one selected from the group consisting of Bi₂O₃, B₂O₃, and V₂O₅, as a solvent, forms a eutectic system, and the melting point can be lowered by mixing the two solvents with each other. When PbO and B₂O₃ are mixed with each other, the melting point of the PbO+B₂O₃ mixture can be set to be the melting point of PbO alone, or lower, within the range in which the PbO concentration is 2 to 96 mol %. This means that the amount of PbO evaporated in the above-described PbO concentration range can be suppressed, compared to PbO alone. On the other hand, although B₂O₃ has a low melting point of 450°C, its viscosity is extremely high, and thus, it is difficult to use B₂O₃ alone as a solvent. However, B₂O₃ can be used as a solvent having a moderate viscosity, within the range in which the B₂O₃ concentration is 2 to 65 mol %.

When PbO and B₂O₃ are used, the solvent composition ratio is preferably PbO : B₂O₃ = 35 to 98 mol % : 65 to 2 mol %, and more preferably PbO : B₂O₃ = 50 to 90 mol % : 50 to 10 mol %.

When PbO and V₂O₅ are used, the solvent composition ratio is preferably PbO : V₂O₅ = 40 to 95 mol % : 60 to 5 mol % 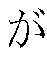 , and more preferably PbO : V₂O₅ = 45 to 80 mol % : 55 to 20 mol %.

When PbF₂ and B₂O₃ are used, the solvent composition ratio is preferably PbF₂ : B₂O₃ = 35 to 90 mol % : 65 to 10 mol %, and more preferably PbF₂ : B₂O₃ = 60 to 80 mol % : 40 to 20 mol %.

Since the LPE growth temperature (temperature during epitaxial growth) becomes high when a single solvent is used, the mixed solvents as described above are preferable.

The mixing ratio between (1) Ga₂O₃ as a solute and (2) a combination of either PbO or PbF₂ as a solvent and any one selected from the group consisting of Bi₂O₃, B₂O₃, and V₂O₅, as a solvent (provided that a combination of PbO and Bi₂O₃ is excluded), is preferably the solute : the solvent = 5 to 30 mol % : 95 to 70 mol %. More preferably, the solute concentration is 7 mol % or more and 26 mol % or less. If the solute concentration is less than 5 mol %, the crystal growth rate becomes slow. On the other hand, if the solute concentration exceeds 30 mol %, the LPE growth temperature becomes high, and solvent volatilization may increase. Also, if the solute concentration exceeds 30 mol %, the crystal growth rate becomes too fast, and the crystal quality may be deteriorated.

In one embodiment of the present invention, the growth rate of the layer (epitaxial layer) containing β-Ga₂O₃ single crystals formed according to liquid phase epitaxy is preferably 10 to 50 µm/hr, and more preferably 20 to 30 µm/hr. If the growth rate is less than 10 µm/hr, the growth rate may be slow and the cost may increase. Also, if the growth rate exceeds 50 µm/hr, the crystal quality may be deteriorated. Herein, the growth rate can be obtained from the difference in film thickness before and after LPE growth and the growth time.

In one embodiment of the present invention, for the purpose of controlling the LPE growth temperature, adjusting the solvent viscosity, and doping foreign elements, one or two or more types of third components can be added to the solvent within a range in which the solubility of Ga₂O₃ and the evaporated amount of the solvent combination (2) above do not change significantly. Examples of such third components may include P₂O₅, MoO₃, WO₃, Ba₂O₃, La₂O₃, and Ge₂O₃.

The growth method of the β-Ga₂O₃ multilayer body in the present invention is most preferably liquid phase epitaxy using a β-Ga₂O₃ substrate.

In a β-Ga₂O₃ multilayer body useful as a power device, it is necessary to control the residual electron concentration of the epitaxial layer. Ga in β-Ga₂O₃ is a trivalent oxide, and generally exhibits n-type conductivity. In one embodiment of the present invention, the residual electron concentration, band gap, insulating properties, etc. can be imparted by doping foreign elements to β-Ga₂O₃. For example, by doping MgO or ZnO as divalent impurities to β-Ga₂O₃, the residual electrons can be reduced. Also, by doping SiO₂ or SnO₂ as tetravalent impurities to β-Ga₂O₃, the residual electron concentration can be increased. Also, by doping FeO to β-Ga₂O₃, insulating properties can be imparted. On the other hand, by doping MgO or Al₂O₃, which has a wider band gap than β-Ga₂O₃, and forming a mixed crystal, the band gap can be enhanced. Also, by doping ZnO or CdO to β-Ga₂O₃ and forming a mixed crystal, the band gap can be reduced.

The layer containing the β-Ga₂O₃ single crystals formed by liquid phase epitaxy preferably comprises one or more types of foreign elements selected from the group consisting of Be, Mg, Ca, Sr, Ba, Ti, Zr, Hf, Fe, Co, Ni, Cu, Zn, Cd, Al, In, Si, Ge, Sn, Pb, and Bi.

The layer containing the β-Ga₂O₃ single crystals formed by liquid phase epitaxy preferably comprises 0.01 mol % or more and 20 mol % or less of foreign elements. The content of the foreign elements is more preferably 0.1 mol % or more, and further preferably 0.5 mol % or more. On the other hand, the content of the foreign elements is more preferably 10 mol % or less. If the doping amount of the foreign elements is less than 0.01 mol %, the characteristics may not be expressed well, and if it exceeds 20 mol %, crystal growth may become difficult.

The layer containing the β-Ga₂O₃ single crystals formed by liquid phase epitaxy comprises one or more types of foreign elements selected from the group consisting of Be, Mg, Ca, Sr, Ba, Ti, Zr, Hf, Fe, Co, Ni, Cu, Zn, Cd, Al, In, Si, Ge, Sn, Pb, and Bi, preferably in the range of 0.01 to 20 mol %, more preferably in the range of 0.1 to 20 mol %, and particularly preferably in the range of 0.5 to 10 mol %. If the doping amount of the foreign elements is less than 0.01 mol %, the characteristics may not be expressed well, and if it exceeds 20 mol %, crystal growth may become difficult.

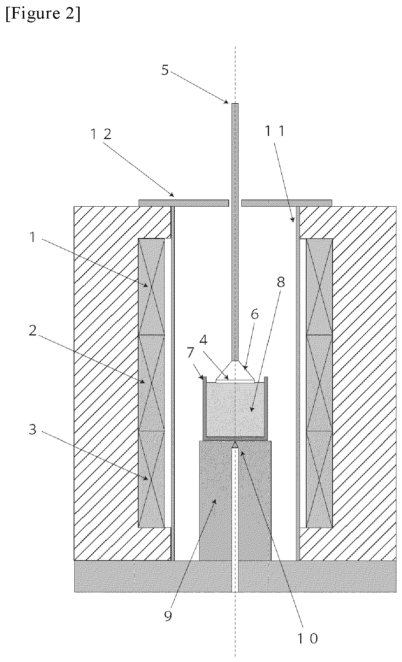

Figure 2 is a schematic diagram showing one example of a common LPE growth furnace. In the LPE growth furnace, a platinum crucible 7 that melts the raw materials and stores them as a melt 8 is placed on a crucible stand 9 made of mullite (a compound of aluminum oxide and silicon dioxide). Outside the platinum crucible 7, which is in the lateral direction, three-stage side heaters (an upper heater 1, a central heater 2, and a lower heater 3) are installed to heat and melt the raw materials in the platinum crucible 7. The heaters are independently controlled in terms of output, and the amount of heat applied to the melt 8 is independently adjusted. A furnace core tube 11 made of mullite is established between the heaters and the inner wall of the production furnace, and a furnace cover 12 made of mullite is established on the top of the furnace core tube 11. A pulling mechanism is established above the platinum crucible 7. A pulling shaft 5 made of alumina is fixed to the pulling mechanism, and at the tip thereof, a substrate holder 6 and a substrate 4 fixed by the holder are established. A mechanism for rotating the shaft is provided above the pulling shaft 5. Other than these, a thermocouple 10 is also provided at the bottom of the crucible.

Another embodiment of the present invention relates to a β-Ga₂O₃/β-Ga₂O₃ multilayer body obtained by the above-mentioned production method, wherein the multilayer body has a layer containing β-Ga₂O₃ single crystals on a β-Ga₂O₃ substrate.

In one embodiment of the present invention, the rocking curve half-width in the layer containing the β-Ga₂O₃ single crystals is preferably 5 to 100 arcsec, more preferably 5 to 95 arcsec, and further preferably 5 to 90 arcsec. If the rocking curve half-width exceeds 100 arcsec, there may be a case where the crystallinity is low and the power device performance is deteriorated. The β-Ga₂O₃/β-Ga₂O₃ multilayer body of the present invention is characterized by high crystallinity. In the present invention, the method described in the Examples below can be adopted as a method of measuring the rocking curve half-width.

### Examples

Hereinafter, a method of forming a β-Ga₂O₃ epitaxial layer on a β-Ga₂O₃ substrate will be described as a method of allowing the growth of the β-Ga₂O₃/β-Ga₂O₃ multilayer body according to one embodiment of the present invention. The present invention is not limited to the following examples at all.

One example of the production method of the present invention will be described below, with reference to Figure 2.

A platinum crucible 7, which melts the raw materials and stores them as a melt 8, is placed on a crucible stand 9. Outside the platinum crucible 7, which is in the lateral direction, three-stage side heaters (an upper heater 1, a central heater 2, and a lower heater 3) are installed to heat and melt the raw materials in the platinum crucible 7. The heaters are independently controlled in terms of output, and the amount of heat applied to the melt 8 is independently adjusted. A furnace core tube 11 is established between the heaters and the inner wall of the production furnace, and a furnace cover 12 is established on the top of the furnace core tube 11. A pulling mechanism is established above the platinum crucible 7. A pulling shaft 5 made of alumina is fixed to the pulling mechanism, and at the tip thereof, a substrate holder 6 and a substrate 4 (β-Ga₂O₃ substrate) fixed by the holder are established. A mechanism for rotating the shaft is provided above the pulling shaft 5. Other than these, a thermocouple 10 is also provided at the bottom of the crucible.

In order to melt the raw materials in the platinum crucible 7, the production furnace is heated until the raw materials are melted. The temperature is increased up to preferably 600°C to 1000°C, more preferably 700°C to 900°C, and the raw materials are left at rest for 2 to 3 hours to homogenize the raw material melt. Alternatively, instead of leaving at rest, a plate made of platinum may be fixed to the tip of the alumina shaft, which is then immersed in the melt, and the melt may be homogenized by a stirring operation involving rotation of the shaft. It is desired that the growth of the β-Ga₂O₃ single crystal layer proceeds only directly below the substrate. If the growth of the growth of the β-Ga₂O₃ single crystals proceeds in the melt other than directly below the substrate, the grown single crystals will adhere to the substrate due to the convection in the melt, and will become a different phase with a different growth orientation, which is unfavorable. Therefore, the three-stage heaters are offset to adjust the bottom of the crucible to be several degrees higher than the surface of the melt. After the temperature of the melt has become stable, the seed crystal substrate is allowed to come into contact with the surface of the melt. After the seed crystal substrate has been allowed to well fit in the melt, the temperature starts to be decreased either at a constant temperature or at a rate of 0.025 to 5°C/hr, and a β-Ga₂O₃ single crystal layer of interest is allowed to grow on the surface of the seed crystal substrate. During the growth, the seed crystal substrate is rotated at 5 to 300 rpm by the rotation of the growth shaft, and is rotated in the opposite direction at regular intervals. After crystal growth for about 30 minutes to 24 hours, the growth shaft is lifted to separate the grown crystals from the melt, and the growth shaft is then rotated at 50 to 300 rpm to separate the melt components attached to the grown crystal surface. Thereafter, the resultant is cooled to room temperature over 1 to 24 hours, so that the β-Ga₂O₃/β-Ga₂O₃ multilayer body of interest can be obtained.

### (Example 1)

Into a platinum crucible 7 with an inner diameter of 75 mm, a height of 75 mm, and a thickness of 1 mm, 1100 g of PbO (purity: 99.999%), 230 g of B₂O₃ (purity: 99.99%), and 250 g of Ga₂O₃ (purity: 99.999%) were added as raw materials. At this time, the mixing ratio between the solute Ga₂O₃ and the solvents PbO and B₂O₃ was the solute : the solvents = 14 mol % : 86 mol %. The mixing ratio between the solvents PbO and B₂O₃ was PbO : B₂O₃ = 60 mol % : 40 mol %. The platinum crucible 7, into which the raw materials had been added, was placed in the LPE furnace shown in Figure 2, and the temperature of the bottom of the crucible was set to about 980°C to melt the raw materials. After stirring the melt for 6 hours using a plate made of platinum, the temperature of the bottom of the crucible was lowered to 850°C (LPE growth temperature), and a β-Ga₂O₃ substrate with a C-plane orientation and a size of 11 mm × 11 mm × 650 µm thick, which had been allowed to grow by the EFG method, was allowed to come into contact with the liquid. Growth was carried out at the same temperature for 3 hours, while rotating a pulling shaft 5 made of alumina at 60 rpm. At this time, the shaft rotation was reversed every 5 minutes. Thereafter, the pulling shaft 5 was pulled up to separate it from the melt, and the melt components were then separated by rotating the pulling shaft 5 at 200 rpm. Thereafter, the resultant was cooled to room temperature to obtain a β-Ga₂O₃/β-Ga₂O₃ multilayer body. The remaining melt components, which had not been removed, were removed using hydrochloric acid. The average thickness of the epitaxial layer was about 72 µm.

### (Comparative Examples 1 and 2)

Each β-Ga₂O₃/β-Ga₂O₃ multilayer body was attempted to be produced by the same method as that in Example 1, with the exceptions that the composition of the raw materials added was changed to obtain the composition shown in Table 1 below, and that the raw material melting temperature and the LPE growth temperature were changed to the values shown in Table 1.

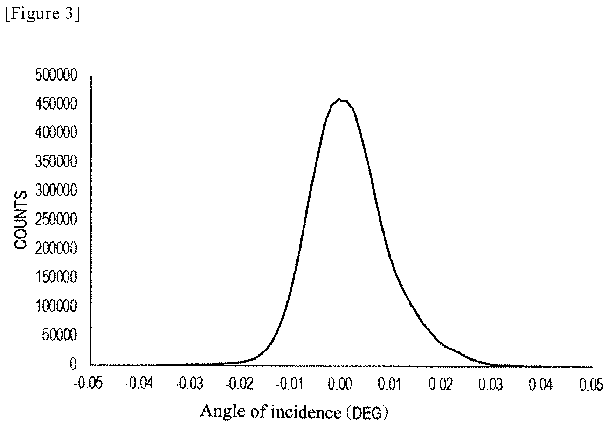

Herein, the crystallinity of the epitaxial layer of the β-Ga₂O₃/β-Ga₂O₃ multilayer body obtained in Example 1 was evaluated with the rocking curve half-width of the (002) surface. The results are shown in Figure 3. The rocking curve half-width of the (002) surface was 0.016 deg (= 56 arcsec). It is to be noted that the rocking curve half-width was measured using an X-ray diffraction device (X'pert MRD manufactured by Spectris). Using this device, the 2θ, ω, χ, and φ were adjusted to set the axis, such that the peak of the (002) surface of β-Ga₂O₃ could be detected, and thereafter, the rocking curve half-width was measured at a tube voltage of 45 KV and a tube current of 40 mA. It is to be noted that the incident light was monochromatized using four crystals of the Ge (220) surface. Other measurement conditions were as follows.
Light source: Cu-Kα
Wavelength: 0.15418 nm
Measurement mode: ω scan (incident angle scan)
ω range: The angle at which the (002) surface of β-Ga₂O₃ appears is set for each sample
ω range: 0.1 deg
ω step: 0.0005 deg
20 position: The angle at which the (002) surface of β-Ga₂O₃ appears is set for each sample
Collimator diameter: 0.5 mm
Anti-scattering slit: 1.5 mm

### (Examples 2 to 11)

Each β-Ga₂O₃/β-Ga₂O₃ multilayer body was obtained by the same method as that in Example 1, with the exceptions that the composition of the raw materials added was changed to obtain the composition shown in Table 1 below, and that the raw material melting temperature and the LPE growth temperature were changed to the values shown in Table 1. Thereafter, the obtained β-Ga₂O₃/β-Ga₂O₃ multilayer body was evaluated in terms of LPE growth rate and the rocking curve half-width of the (002) surface. It is to be noted that the epitaxial layer obtained in Example 4 was a mixed crystal layer of β-Ga₂O₃ and MgO, which contained 5.4 mol % Mg.

**[Table 1]**

| | Each component in solvent | | | Solute Ga₂O₃ amount mol% | Solvent amount mol% | Foreign element MgO mol% | Foreign element SnO mol% | Raw material melting temperature °C | LPE growth temperature °C | LPE growth rate µm/h | Rocking curve half-width arcsec |
|---|---|---|---|---|---|---|---|---|---|---|---|
| | Solvent 1 | Solvent 2 | Solvent composition ratio | | | | | | | | |
| Comp.Ex. 1 | PbO | - | 100:0 | 14 | 86 | 0 | 0 | 1,090 | 990 | - | - |
| Comp.Ex. 2 | - | Bi₂O₃ | 100:0 | 14 | 86 | 0 | 0 | 1,030 | 930 | - | - |
| Example 1 | PbO | B₂O₃ | 60:40 | 14 | 86 | 0 | 0 | 980 | 850 | 24 | 56 |
| Example 2 | PbO | B₂O₃ | 90:10 | 23 | 77 | 0 | 0 | 980 | 860 | 28 | 77 |
| Example 3 | PbO | B₂O₃ | 50:50 | 9 | 91 | 0 | 0 | 980 | 830 | 22 | 95 |
| Example 4 | PbO | B₂O₃ | 60:40 | 14 | 83 | 3.1 | 0 | 980 | 855 | 13 | 88 |
| Example 5 | PbO | B₂O₃ | 60:40 | 14 | 86 | 0.01 | 0 | 980 | 855 | 16 | 62 |
| Example 6 | PbO | B₂O₃ | 60:40 | 14 | 86 | 0.11 | 0 | 980 | 855 | 15 | 60 |
| Example 7 | PbO | B₂O₃ | 60:40 | 14 | 86 | 0 | 0.01 | 980 | 855 | 12 | 58 |
| Example 8 | PbO | B₂O₃ | 60:40 | 14 | 86 | 0 | 0.09 | 980 | 855 | 15 | 66 |
| Example 9 | PbO | V₂O₅ | 45:55 | 20 | 80 | 0 | 0 | 980 | 840 | 20 | 74 |
| Example 10 | PbF₂ | B₂O₃ | 78:22 | 7 | 93 | 0 | 0 | 980 | 770 | 15 | 80 |
| Example 11 | PbF₂ | Bi₂O₃ | 70:30 | 17 | 83 | 0 | 0 | 1,000 | 920 | 12 | 90 |

As described above, a β-Ga₂O₃/β-Ga₂O₃ multilayer body can be produced by: mixing Ga₂O₃ as a solute with a combination of either PbO or PbF₂ as a solvent and any one selected from the group consisting of Bi₂O₃, B₂O₃, and V₂O₅, as a solvent (provided that a combination of PbO and Bi₂O₃ is excluded), and melting the mixture; and then allowing a β-Ga₂O₃ substrate to directly come into contact with the resulting melt. As found by comparing Examples 1 to 11 with Comparative Examples 1 and 2, the solvent melting point can be lowered compared to the case of PbO or PbF₂ alone, by mixing either PbO or PbF₂ with any one selected from the group consisting of Bi₂O₃, B₂O₃, and V₂O₅ (provided that a combination of PbO and Bi₂O₃ is excluded). Therefore, both the raw material melting temperature and the β-Ga₂O₃ growth temperature become lower than those when a single solvent is used. This means that the amount of the solvent components evaporated can be reduced. According to the present method, since the amount of the solvents evaporated is suppressed, stable crystal growth can be performed with little compositional variation, and consumption of furnace materials can be suppressed, so that the growth furnace does not need to be a closed system. Accordingly, production at low costs becomes possible. In addition, as described above, the present invention involves a liquid phase growth method close to thermal equilibrium growth. Therefore, the growth rate is fast at 12 to 28 µm/hr, and as shown in Table 1 above, the rocking curve half-width of the (002) surface of the β-Ga₂O₃ epitaxial layer according to the LPE method is narrow at 56 to 95 arcsec, and it has high crystallinity. On the other hand, in Comparative Examples 1 and 2, since melting did not occur unless heat exceeding 1000°C was applied, and the solvent was volatilized at a temperature exceeding 1000°C, a multilayer body could not be produced.

### Reference Signs List

- 1: Upper heater
- 2: Central heater
- 3: Lower heater
- 4: Substrate
- 5: Pulling shaft (made of alumina)
- 6: Substrate holder
- 7: Platinum crucible
- 8: Melt in crucible
- 9: Crucible stand (made of mullite)
- 10: Crucible bottom thermocouple
- 11: Furnace core tube (made of mullite)
- 12: Furnace cover (made of mullite)

## Claims

1. A method for producing a β-Ga₂O₃/β-Ga₂O₃ multilayer body, the method comprising: mixing (1) Ga₂O₃ as a solute, with (2) a combination of either PbO or PbF₂ as a solvent and any one selected from the group consisting of Bi₂O₃, B₂O₃, and V₂O₅, as a solvent (provided that a combination of PbO and Bi₂O₃ is excluded), and melting the mixture; and then allowing a β-Ga₂O₃ substrate to directly come into contact with the resulting melt, so that β-Ga₂O₃ single crystals are allowed to grow on the β-Ga₂O₃ substrate according to liquid phase epitaxy.

2. The production method according to claim 1, wherein the combination (2) above is a combination of PbO as a solvent and any one selected from the group consisting of B₂O₃ and V₂O₅ as a solvent, or a combination of PbF₂ as a solvent and B₂O₃ as a solvent.

3. The production method according to claim 1 or 2, wherein the layer containing the β-Ga₂O₃ single crystals formed according to liquid phase epitaxy contains 0.01 mol % or more and 20 mol % or less of a foreign element.

4. The production method according to claim 3, wherein the foreign element is one or more selected from the group consisting of Be, Mg, Ca, Sr, Ba, Ti, Zr, Hf, Fe, Co, Ni, Cu, Zn, Cd, Al, In, Si, Ge, Sn, Pb, and Bi.

5. A β-Ga₂O₃/β-Ga₂O₃ multilayer body obtained by the production method according to any one of claims 1 to 4, wherein the multilayer body has a layer containing β-Ga₂O₃ single crystals on a β-Ga₂O₃ substrate.

6. The β-Ga₂O₃/(3-Ga₂O₃ multilayer body according to claim 5, wherein a rocking curve half-width in the layer containing the β-Ga₂O₃ single crystals is 5 to 100 arcsec.

7. An optical material comprising the β-Ga₂O₃/β-Ga₂O₃ multilayer body according to claim 5 or 6.

8. An electronic device comprising the β-Ga₂O₃/β-Ga₂O₃ multilayer body according to claim 5 or 6.
